# EUROPEAN PATENT APPLICATION

(11) **EP 4 254 288 A1**
(43) Date of publication of application: **04.10.2023**
(21) Application number: 23164883.3
(22) Date of filing: 29.03.2023
(51) Int. Cl.: G06Q 10/087, G06Q 50/16

(54) **DATA MANAGEMENT SYSTEM, MANAGEMENT METHOD, AND MANAGEMENT PROGRAM**

(30) Priority: 29.03.2022 JP 2022053555
(71) Applicant: TOPCON CORPORATION, Tokyo 174-8580 (JP)
(72) Inventor: Doji, Atsushi, Itabashi-ku, Tokyo, 174-8580 (JP); Ito, Tadayuki, Itabashi-ku, Tokyo, 174-8580 (JP); Nishita, Nobuyuki, Itabashi-ku, Tokyo, 174-8580 (JP); Dohmoto, Takeshi, Itabashi-ku, Tokyo, 174-8580 (JP)
(74) Representative: dompatent von Kreisler Selting Werner - Partnerschaft von Patent- und Rechtsanwälten mbB

(57) **Abstract**

An object of the present invention is to perform data management in which changes in environment conditions of a building are reflected in data of the building at the time of completion. In order to achieve the object, a management system (1) includes a completion database (3) storing, with respect to a completion member of a building, at least a member ID and member coordinates, an environment database (4) storing, with respect to environment conditions of the building including the completion member after completion or an object related to the completion member, at least an environment acquisition result ID and environment acquisition coordinates, an operation model creating unit (5) configured to extract, as an operation member, the completion member related to the environment conditions acquired, and create an operation model of the operation member, and an operation database (8) in which, with respect to the operation member, an operation member ID, the member ID, operation member coordinates, and an operation member shape are stored based on the operation model.

## Description

### Technical Field

The present invention relates to a system, method, and program for maintaining and managing a building after completion.

### Background Art

In recent years, in the field of construction, utilization of a 3D model called BIM (Building Information Modeling) has been promoted. BIM is 3D modeling of a building to be reproduced on a computer, and a 3D model of each member can be created. BIM has been increasingly utilized at building design sites (planning, architectural design, facility design, design analysis, execution design, construction planning, and component manufacturing), however, it is said that there is a delay in utilization of BIM at building construction sites. Accordingly, the applicant has proposed a technology to utilize BIM at construction sites as described below. Based on Patent Literatures 1 to 4, a 3D model (hereinafter, referred to as "construction model") can be created in which information on a construction process is reflected in design BIM.

### Citation List

### Patent Literature

Patent Literature 1: Japanese Published Unexamined Patent Application No. 2021-89498
Patent Literature 2: Japanese Published Unexamined Patent Application No. 2021-099673
Patent Literature 3: Japanese Published Unexamined Patent Application No. 2021-124867
Patent Literature 4: Japanese Published Unexamined Patent Application No. 2021-131751

### Summary of Invention

### Technical Problem

However, it is considered that there is a delay in utilization of BIM not only during building construction but also after completion of building construction. After completion, it is necessary to maintain and manage the building and periodically inspect whether the building has been properly used. However, for this inspection, planning may be performed according to drawings and data at the time of completion of the building, and problems often occur in which current environment conditions of the building are not consistent with the completion drawing. As a result, problems with difficulty in planning or incorrect planning often arose.

The present invention was made in view of these problems, and an object thereof is to perform data management to reflect changes in environment conditions of the building in data at the time of completion of the building.

### Solution to Problem

In order to solve the problems described above, a management system according to an aspect of the present invention includes a completion database storing, with respect to a completion member of a building, at least a member ID and member coordinates, an environment database storing, with respect to environment conditions of the building including the completion member after completion or an object related to the completion member, at least an environment acquisition result ID and environment acquisition coordinates, an operation model creating unit configured to extract, as an operation member, the completion member related to the environment conditions acquired, and create an operation model of the operation member, and an operation database in which, with respect to the operation member, an operation member ID, the member ID, operation member coordinates, and an operation member shape are stored based on the operation model.

In the aspect described above, it is also preferable that the management system further includes a tool work management system including a tool having a communication unit and a trigger switch, a total station having a communication unit, a distance-measuring unit, an angle-measuring unit, and a tracking unit, and a camera having a communication unit, a stereo camera, a posture detecting device, a control unit, and a prism, wherein coordinates of a tip end position of the tool obtained by the tool work management system are acquired as the environment acquisition coordinates and stored in the environment database.

In the aspect described above, it is also preferable that the management system includes the environment database further including a change point extracting unit configured to acquire the environment acquisition coordinates in the environment database, select the completion member whose change is to be confirmed, as a change point confirming member, and extract coordinates not falling within a member range of a member shape of the change point confirming member among the environment acquisition coordinates as "Changed", and a change confirmation table storing, with respect to the environment acquisition coordinates extracted as "Changed" by the change point extracting unit, a change confirmation ID, the member ID, the environment acquisition coordinates, and the presence/absence of a change, in association with each other.

In order to solve the problems described above, a management method according to an aspect of the present invention includes the steps of: by transmitting and receiving information to and from a completion database storing, with respect to a completion member of a building, at least a member ID and member coordinates, and an environment database storing, with respect to environment conditions of the building including the completion member or an object related to the completion member, at least an environment acquisition result ID and environment acquisition coordinates, (A) acquiring the environment conditions from the environment database, (B) extracting, as an operation member, the completion member related to the environment conditions acquired in Step (A), (C) creating, with respect to the operation member, an operation model by applying shape correction to a completion model created from the completion database by using data on the environment conditions, and (D) storing, with respect to the operation member, an operation member ID, the member ID, operation member coordinates, and an operation member shape in an operation database based on the operation model.

In the aspect described above, it is also preferable that the management method further includes the step of: by transmitting and receiving information to and from a tool work management system including a tool having a communication unit and a trigger switch, a total station having a communication unit, a distance-measuring unit, an angle-measuring unit, and a tracking unit, and a camera having a communication unit, a stereo camera, a posture detecting device, a control unit, and a prism, (E) receiving coordinates of a tip end position of the tool as the environment acquisition coordinates from the tool work management system and storing the received coordinates in the environment database, wherein the operation model is created through the step (C) or the step of (F) creating, as an operation model of the operation member, a shape model representing a member shape of the completion member from the environment acquisition coordinates acquired by the tool work management system.

In the aspect described above, it is also preferable that the management method includes the steps of: (G) creating a completion model from the completion database, (H) acquiring the environment acquisition coordinates from the environment database, (I) selecting the completion member whose change is to be confirmed as a change point confirming member from the completion model, (J) acquiring a member shape of the change point confirming member, (K) extracting coordinates not falling within a member range of the member shape of the change point confirming member as "Changed" among the environment acquisition coordinates, and (L) creating a change confirmation table in which, with respect to the environment acquisition coordinates extracted as "Changed" in the step (K), a change confirmation ID, the member ID, the environment acquisition coordinates, and the presence/absence of a change, are associated with each other, and storing the change confirmation table in the environment database.

In the aspect described above, it is also preferable that the management method includes the step of: (M) extracting the environment conditions stored as the "Changed" from the change confirmation table, and presenting the extracted environment conditions to a manager.

It is also preferable that the management method according to the aspect described above is described as a computer program and execution of the computer program is enabled.

### Advantageous Effects of Invention

According to a data management system, management method, and management program of the present invention, data management for reflecting changes in environment conditions of a building in data at the time of completion of the building can be performed.

### Brief Description of Drawings

FIG. 1 is a configuration block diagram of a management system 1 according to a first embodiment of the present invention.
FIG. 2 is a diagram illustrating an example of a completion database 3 in the same management system 1.
FIG. 3 is a diagram illustrating an example of an environment database 4 in the same management system 1.
FIG. 4 is a diagram illustrating an example of an operation database 8 in the same management system 1.
FIG. 5 is a flowchart of a management method according to the first embodiment of the present invention.
FIGS. 6 are work image views of the same management method.
FIG. 7 is a configuration diagram of a management system 1' according to a second embodiment of the present invention.
FIG. 8 is a configuration diagram of a management system 1" according to a third embodiment of the present invention.
FIG. 9 is a flowchart of a management method (assignment of "Changed"/"Unchanged") according to the third embodiment of the present invention.
FIG. 10 is a flowchart of a management method (confirmation of change point) according to the third embodiment of the present invention.

### Description of Embodiments

Next, preferred embodiments of the present invention will be described with reference to the drawings. The same or equivalent components, members, and processes illustrated in the respective drawings, are provided with the same reference signs, and overlapping descriptions will be omitted as appropriate.

### <First Embodiment>

### (Configuration of Management System)

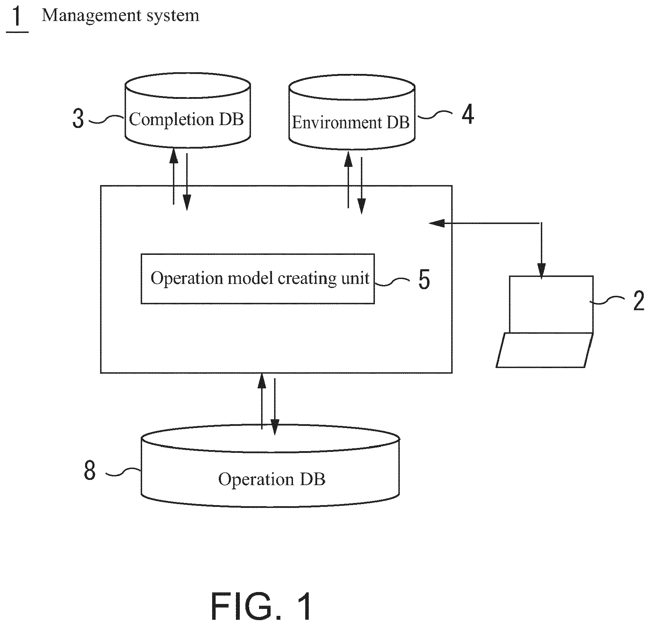

FIG. 1 is a configuration block diagram of a management system 1 according to a first embodiment of the present invention. The management system 1 includes an input/output device 2, a completion database 3, an environment database 4, an operation model creating unit 5, and an operation database 8.

The input/output device 2 is a general-purpose personal computer, tablet terminal, etc., including at least an arithmetic unit, a recording unit, a communication unit, a display unit, and an operation unit, and can be operated by a manager.

The operation model creating unit 5 (hereinafter, also referred to as "functional unit") consists of electronic circuits of a CPU (Central Processing Unit), an ASIC (Application Specific Integrated Circuit), a PLD (Programmable Logic Device) such as an FPGA (Field Programmable Gate Array), etc. The functional unit may be configured inside the input/output device 2 or configured by either separate external hardware/software. In the latter case, the functional unit can transmit and receive information to and from the input/output device 2 through a communication network.

The completion database 3, the environment database 4, and the operation database 8 are stored in the same or different server computers configured to be capable of communicating with each other through a communication network. The server computer (s) can communicate with the functional unit, and transmit and receive information to and from the functional unit.

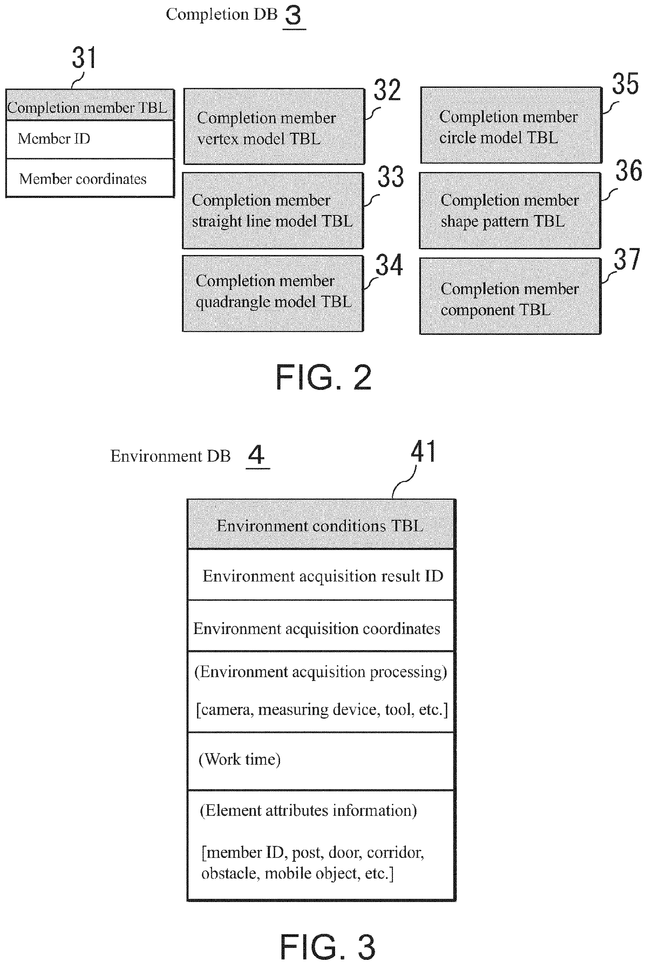

In the completion database 3, data on construction members at the time of completion (hereinafter, referred to as "completion members") of a building to be managed are stored. The completion database 3 includes, as illustrated in FIG. 2, a completion member table 31 in which, with respect to a completion member, at least identification information (member ID) of the completion member and coordinates of the completion member (member coordinates) are associated with each other. The completion member table 31 may be created by reading coordinates described on a drawing at the time of completion or may be created by using coordinate data of the building at the time of completion measured with a measuring device such as a scanner.

Alternatively, it is also preferable that the completion member table 31 is created by using coordinate data in a "design correction database" disclosed in Patent Literature 1 or a "corrected construction plan database" disclosed in Patent Literature 2. When coordinate data of Patent Literature 1 and Patent Literature 2 are used, information on a construction model can be taken over, so that a "completion model" (construction model at the time of completion. A 3D model of the building at the time of completion reproduced on a computer, and data that enables creation of a 3D model of each completion member. The 3D model includes shapes of surfaces, lines, and points) can be created.

Alternatively, it is also preferable that the completion member table 31 is created from a work management system (hereinafter, referred to as "tool work management system") disclosed in Japanese Published Unexamined Patent Application No. 2021-173727 and the construction model creation system (hereinafter, referred to as "tool construction model creation system") disclosed in Japanese Published Unexamined Patent Application No. 2022-6508 proposed by the applicant. The reference signs 32 to 37 in FIG. 2 relates to the tool construction model creation system, and will be described in detail later.

In the environment database 4, data on "environment conditions" after completion of the building to be managed are stored as needed. In this description, completion members after completion and objects related to the completion members (various objects other than completion members, related to the completion members in terms of coordinates) are collectively referred to as "environment conditions." The environment database 4 includes, as illustrated in FIG. 3, an environment conditions table 41 in which at least environment conditions identification information (an environment acquisition result ID) and environment conditions coordinates (environment acquisition coordinates) are associated with each other. The environment conditions table 41 is created by using coordinate data obtained with measuring devices such as a camera, a scanner, and a total station (point cloud data in which coordinate information is registered, point data, screen data holding coordinate information of measurement points, and data on construction errors of construction members, etc.).

Preferably, in order to enable information extraction based on the measuring device, information on a measuring device (camera, scanner, total station, tool, etc.) that acquired environment conditions ("environment acquisition processing") may be stored in the environment conditions table 41. In order to enable information extraction based on time, information on a time of acquisition of environment conditions ("work time") may be stored. In order to enable information extraction based on element attributes of environment conditions, a name of the environment conditions, or when a member ID in the completion member table 31 is assigned to coordinates, the member ID, may be stored as "element attributes information." The element attributes information includes not only attributes information of a completion member but also attributes information of objects (such as obstacles and mobile objects (including persons/machines)) related to the completion member.

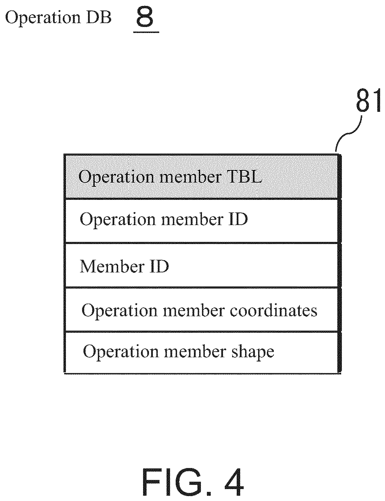

In the operation database 8, data on a completion member related to acquired environment conditions (that is, a completion member which is likely to have been changed after completion due to a change in environment conditions. Hereinafter, referred to as "operation member") is recorded as needed. The operation database 8 stores, as illustrated in FIG. 4, an operation member table 81 in which at least operation member identification information (operation member ID), a member ID of a completion member that has become the operation member (linked to the completion member table 31), coordinates of the operation member (operation member coordinates) and a shape of the operation member (operation member shape) are associated with each other.

The operation model creating unit 5 creates an "operation model" (described later) from data in the completion database 3 and the environment database 4, and creates an operation database 8. Details will be described in a management method to be described next.

### (Management Method)

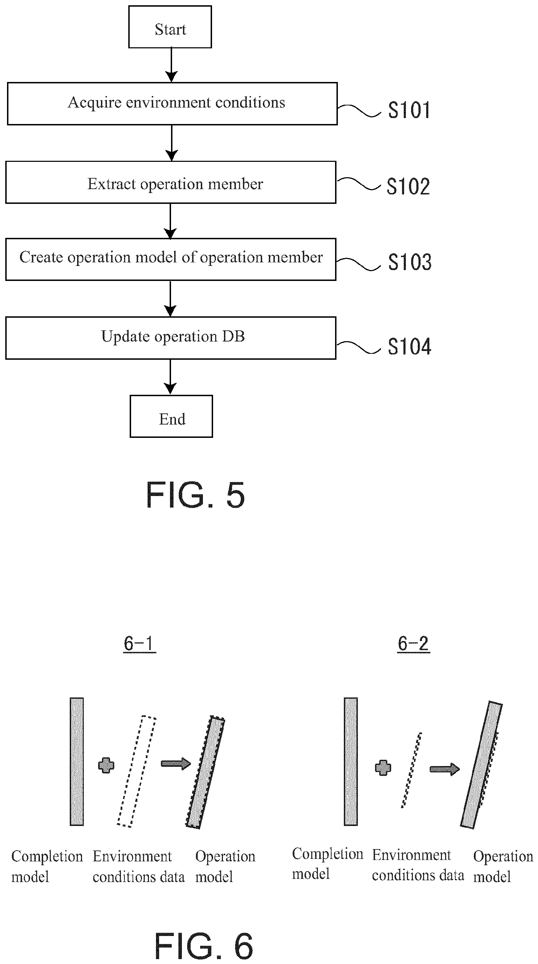

FIG. 5 is a flowchart of a management method according to the first embodiment of the present invention. As management processing is started, first, in Step S101, environment conditions are acquired. Next, the processing shifts to S102, and an operation member related to the acquired environment conditions is extracted. Next, the processing shifts to S103, and an "operation model" (described later) of the operation member is created. Next, the processing shifts to Step S104, and based on the operation model, the operation database 8 is updated. As the operation database 8 is updated, the management processing is ended.

Specifically, in Step S101, the operation model creating unit 5 accesses the environment database 4, reads out the environment conditions table 41, and acquires data on the environment conditions. The operation model creating unit 5 functions when a change is made in the environment conditions table 41 or when a manager accesses the environment database 4 through the input/output device 2. As the data on the environment conditions, data added since previous management processing, data which was not managed in the previous management processing, or data selected by the manager, is acquired.

Next, the processing shifts to S102, and when element attributes information of the environment conditions acquired in Step S101 includes a member ID, the operation model creating unit 5 extracts a corresponding completion member as an operation member from the completion member table 31. When there is no element attributes information, environment acquisition coordinates of the environment conditions are displayed on the input/output device 2, and based on the coordinates, the manager is prompted to extract an operation member.

Next, the processing shifts to S103, and the operation model creating unit 5 creates an "operation model" (a 3D model of a building reflecting environment conditions of the building, reproduced on a computer, and data from which each operation member can be created as a 3D model. The 3D model includes shapes of surfaces, lines, and points).

When a shape of the operation member can be obtained from the data on the environment conditions, for example, as indicated by the reference sign 6-1 in FIG. 6, the operation model creating unit 5 creates an operation model by correcting a completion model of the operation member into a shape based on the coordinate data of the environment conditions. Alternatively, when some information (surfaces, lines, and points) related to the shape of the operation member can be obtained from the data on the environment conditions, as indicated by the reference sign 6-2 in FIG. 6, the operation model creating unit 5 creates an operation model by correcting disposition coordinates, rotation, or a tilt of a completion model of the operation member.

Next, the processing shifts to Step S104, and the operation model creating unit 5 assigns an operation member ID to the operation member, and updates the operation member table 81 based on the operation model by storing the member ID of the completion member that has become the operation member, operation member coordinates, and an operation member shape in the operation member table 81.

As described above, according to the management system 1 and the management method of the present embodiment, by creating an operation model, a building can be managed by reflecting changes in environment conditions (changes based on coordinates) after completion of the building into data at the time of completion of the building. After completion of the building, it is necessary to inspect whether the building is properly operated. For this inspection, by creating a plan by using an operation model reflecting a current state of a completion member which has changed in the environment conditions, it is possible to prevent an inappropriate inspection from being made. In addition, the authority to maintain and manage a building is generally transferred from a constructor to an owner of the building, and BIM is not taken over. Therefore, analog management is performed by the owner of the building in many cases. However, by using the management system 1 and the management method of the present embodiment, BIM can also be utilized for maintaining and managing the building.

### <Second Embodiment>

### (Configuration of Management System)

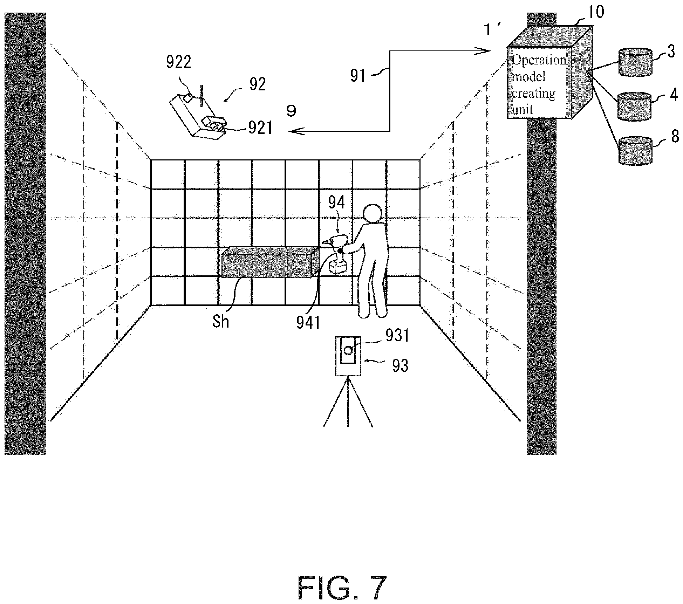

FIG. 7 is a configuration diagram of a management system 1' according to a second embodiment of the present invention. The management system 1' of the present embodiment combines the tool work management system and the tool construction model creation system described above with the management system 1 (FIG. 1) of the first embodiment. The tool work management system is disclosed as a system to manage a work during construction, however, in the present embodiment, the tool work management system is a system to monitor environment conditions after completion and automatically create the environment conditions table 41. The tool construction model creation system is disclosed as a system to create a construction model based on a work result at the time of construction, however, in the present embodiment, the tool construction model creation system is a system to create an operation model based on information in the environment conditions table 41.

In FIG. 7, the reference sign 91 denotes a communication network, the reference sign 92 denotes a camera, the reference sign 93 denotes a total station, and the reference sign 94 denotes a tool. The tool 94 includes a communication unit (not illustrated) and a trigger switch 941. The camera 92 includes a communication unit (not illustrated), a stereo camera 921, a posture detecting device (not illustrated) such as an IMU, a control unit (not illustrated) including a CPU, and a prism 922. The total station 93 includes a distance-measuring unit (931) that measures a distance to the prism 922 by transmitting and receiving distance-measuring light, a communication unit (not illustrated), a tracking unit (not illustrated) that automatically tracks the prism 922 by images, and an angle-measuring unit (not illustrated) such as an encoder. The camera 92, the total station 93, and the tool 94 are elements related to a tool work management system 9, and for details of respective configurations of these, descriptions of the tool operation management system can be cited. The management system 1' includes the tool work management system 9, and a server computer 10 including the operation model creating unit 5. The server computer 10 can communicate with the completion database 3, the environment database 4, and the operation database 8 by wire or wirelessly. The operation model creating unit 5 can perform the construction model creating method of the tool construction model creation system to create an operation model, and for details of the method, the description of the tool construction model creation system can be cited.

In the building in FIG. 7, a rectangular design shelf Sh that had not been provided at the time of completion is attached by using the tool 94. According to the tool work management system 9, upon detecting turning ON/OFF of the trigger switch of the tool 94, the camera 92 collects its own posture information, a tool image of the tool 94, position coordinates of the prism P measured with the total station 93, and direction information of the camera 92 as viewed from the total station 93, and obtains coordinates of a tip end position of the tool 94. The camera 92 transmits information including coordinates of the tip end position of the tool 94 and tool information (the type of the tool, a tool ID, shape information of the tool, and information on a position defined as the tip end position of the tool) as "environment acquisition information" to the server computer 10. Upon receiving the environment acquisition information from the tool work management system 9, the server computer 10 assigns an environment acquisition result ID to this work, and stores coordinates of the tip end position of the tool 94 as environment acquisition coordinates, the type of the tool 94 (screwdriver, impact wrench, welder, reinforcing bar binder, etc.) as environment acquisition information, and a work time and element attributes information (wall A, shelf) in the environment conditions table 41. In this regard, as for assignment of element attributes information, manual assignment by the manager is possible. However, it is also preferable to use the technology disclosed in Patent Literature 3. Specifically, the technology to determine whether coordinates (object point) acquired with the measuring device are coordinates of a shape calculation member is used. Accordingly, whether coordinates of the tip end position of the tool 94 are coordinates of the completion member (wall A) is determined, and a member ID is automatically assigned. Alternatively, as assignment of element attributes information, it is also preferable that, by using a publicly known image identification means (machine learning type classifier, etc.), a completion member name or an object name related to the completion member is automatically identified.

### (Management Method)

A flow of a management method according to the second embodiment is similar to the flowchart (FIG. 5) of the management method according to the first embodiment, so that description will be given by citing the flowchart. In the management system 1', as management processing is started, in Step S101, the operation model creating unit 5 functions when the management system 1' updates the environment conditions table 41, and acquires data on environment conditions that has changed in the environment conditions table 41.

Next, the processing shifts to S102, and when a member ID is included in element attributes information of the environment conditions acquired in Step S101, the operation model creating unit 5 extracts a corresponding completion member as an operation member from the completion member table 31. When there is no element attributes information, environment acquisition coordinates of the environment conditions are displayed on the input/output device 2, and based on the coordinates, the manager is prompted to extract an operation member.

Next, the processing shifts to S103, and the operation model creating unit 5 creates an operation model by using the construction model creating method of the tool construction model creation system.

In the tool construction model creation system, from coordinates of a tip end position of a tool and a member shape pattern of a construction member, a shape model (a line segment model, a quadrangle model, a circle model) representing a member shape of the construction member can be created. Information in a "vertex model table," a "straight line model table," a "quadrangle model table, " a "circle model table, " a "member shape pattern table," and a "construction member component table" of a "construction model database" of the tool construction model creation system are respectively linked to member coordinates in the completion member table 31, and are stored as a completion member vertex model table 32, a completion member straight line model table 33, a completion member quadrangle model table 34, a completion member circle model table 35, a completion member shape pattern table 36, and a completion member component table 37 in the completion database 3 (refer to FIG. 2). In the completion member vertex model table 32, for each vertex of the completion model, identification information and vertex coordinates are stored. In the completion member straight line model table 33, for each straight line of the completion model, identification information, a start point of the straight line and an end point of the straight line, or vector information, are stored. In the completion member quadrangle model table 34, for each quadrangle model of the completion model, an identification number and vertex coordinates are stored. In the completion member circle model table 35, for each circle model of the completion model, identification information, center point coordinates, and a diameter or radius are stored. In the completion member shape pattern table 36, identification information (shape pattern ID) and shape information of a member shape pattern of the completion member are stored. In the completion member component table 37, a component type of the completion member (main reinforcement/hoop/stirrup reinforcement, etc.) is stored in association with the member ID and the shape pattern ID.

For example, when it is desired to create a line segment model representing a member shape of an operation member having a straight line shape, the operation model creating unit 5 selects a point with smallest coordinates as a "work start point" among environment acquisition coordinates extracted in Step S102, selects three points whose coordinates are near the work start point as "candidate point 1, candidate point 2, and candidate point 3," selects line segments connecting the work start point and the candidate points 1, 2, and 3 as "candidate line segment 1, candidate line segment 2, and candidate line segment 3, " and determines line segments orthogonal to each other as "definite line segments," and concerning line segments not orthogonal to each other, determines only line segments on a straight line as "definite line segments." This work is performed for all environment acquisition coordinates, and line segments determined as "definite line segments" are set as a line segment model of the operation member, that is, an operation model. When it is desired to create a quadrangle model representing a member shape of a rectangular operation member, among environment acquisition coordinates extracted in Step S102, a point with smallest coordinates is selected as a "temporary start point," and among the environment acquisition coordinates, a point whose x and y coordinates are equal to those of the temporary start point is selected as a "candidate point," and among candidate points, a point closest to the origin of the x, y, and z axes is set as a "work start point 1," a candidate point closest to the work start point 1 is selected as a "temporary candidate point," a candidate point that is on a straight line passing through the work start point 1 and the temporary candidate point and furthest from the work start point 1 is selected as a "work start point 2, " a candidate point that is orthogonal to a straight line passing through the work start point 1 and the temporary candidate point, passes through the work start point 1 (T1), and is furthest from the work start point 1, is selected as a "work start point 3," a candidate point that is orthogonal to a straight line passing through the work start point 1 and the temporary candidate point, passes through the work start point 2 (T2), and is furthest from the work start point 2, is selected as a "work start point 4," and a set of line segments passing through the work start points 1 to 4 (T1 to T4) is set as a quadrangle model of the operation member, that is, an operation model. When it is desired to create a circle model representing a member shape of a circular operation member, environment acquisition coordinates extracted in Step S102 are projected on a plane perpendicular to the xy plane, points with z coordinates within a certain distance are grouped, and two pairs of arbitrary two points are selected from the grouped points, normal lines orthogonal to line segments passing through the respective points and passing through midpoints of the line segments are created, and a point at which the normal lines cross each other is calculated as a "center point," a diameter is calculated by doubling a distance between the center point and an arbitrary point on the xy plane (radius), and the result is set as a circle model representing the operation member, that is, an operation model. In the case of the shelf Sh (operation member) in FIG. 7, an operation model of the shelf Sh is created by the set of line segment models or the quadrangle model described above.

Next, the processing shifts to Step S104, and the operation model creating unit 5 assigns an operation member ID to the operation member, and based on the operation model, updates the operation member table 81 by storing the member ID of the completion member that has become the operation member, the operation member coordinates, and the operation member shape in the operation member table 81.

As described above, according to the management system 1' and the management method of the present embodiment, the same effect as that of the first embodiment can be obtained, and by combination with the tool work management system 9, a change in environment conditions of the building (change based on coordinates) is automatically acquired, and the environment conditions table 41 is automatically created. By using the tool work management system 9, not only the environment acquisition coordinates but also items of environment acquisition processing, work time, and attributes information can be provided in the environment conditions table 41. Therefore, the operation model creating unit 5 can use the tool construction model system, and the management system 1' can be more effectively used.

### <Third Embodiment>

### (Configuration of Management System)

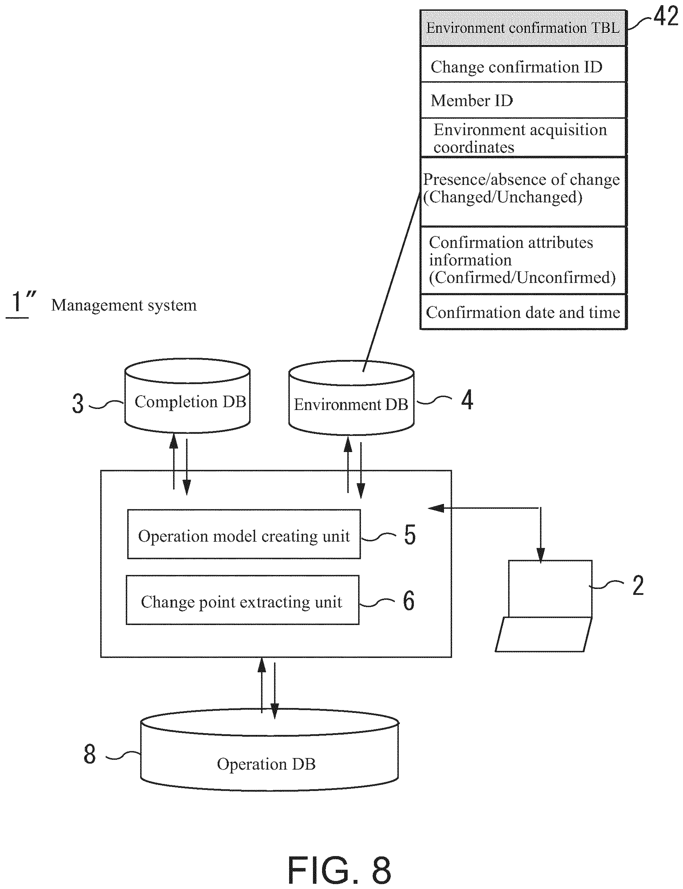

FIG. 8 is a configuration diagram of a management system 1" according to a third embodiment of the present invention. The management system 1" of the present embodiment further includes a change point extracting unit 6 in the management system 1 of the first embodiment. The change point extracting unit 6 is configured as the functional unit described above. The change point extracting unit 6 extracts and confirms the presence/absence of a change according to the environment conditions. Details will be described in a management method to be described next.

In the management system 1" of the present embodiment, the environment database 4 further includes an environment confirmation table 42. In the environment confirmation table 42, data on a changed environment conditions is recorded as needed. In the environment confirmation table 42, new identification information (change confirmation ID) for the changed environment conditions, a member ID linked to the completion member table 31, environment acquisition coordinates of the changed environment conditions, the presence/absence of a change, and a date and time (confirmation date and time) for which a change was confirmed, are stored in association with each other. The environment confirmation table 42 is created by the change point extracting unit 6. In the management system 1" of the present embodiment, the completion database 3 includes the completion member vertex model table 32, the completion member straight line model table 33, the completion member quadrangle model table 34, the completion member circle model table 35, the completion member shape pattern table 36, and the completion member component table 37 (refer to FIG. 2).

### (Management Method: Extraction of presence/absence of change)

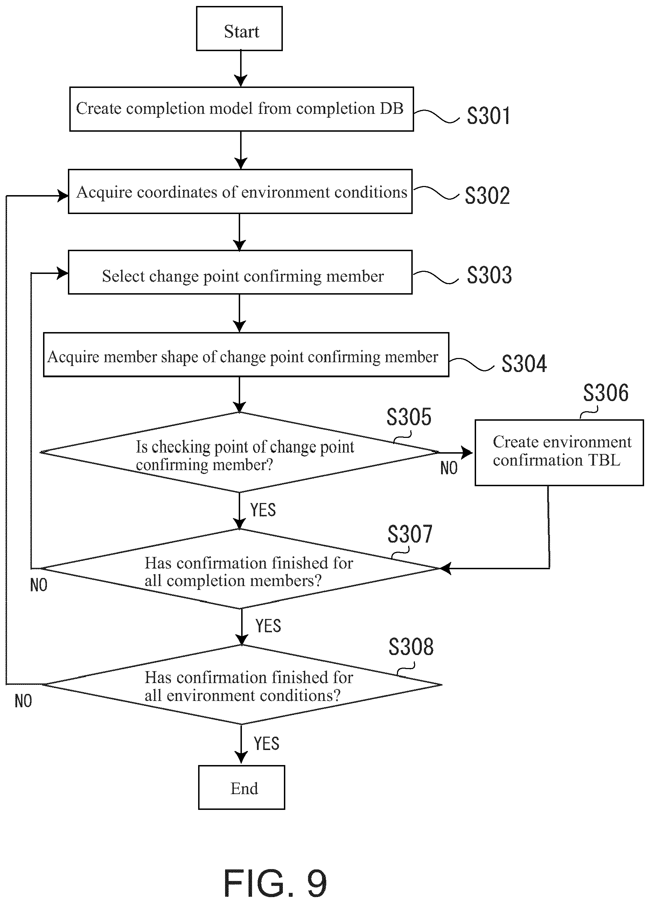

FIG. 9 is a flowchart of a management method according to the third embodiment of the present invention, and is a flow of extracting the presence/absence of a change.

In the management system 1", when management processing (extraction of the presence/absence of a change) is started, in Step S301, the change point extracting unit 6 accesses the completion database 3, reads out the completion member table 31, and creates a completion model.

Next, the processing shifts to S302, and the change point extracting unit 6 accesses the environment database 4, reads out the environment conditions table 41, and acquires environment acquisition coordinates. As environment acquisition coordinates, coordinates added since previous management processing, coordinates which were not managed in the previous management processing, or coordinates selected by the manager are all acquired.

Next, the processing shifts to S303, and the change point extracting unit 6 displays the completion model on the input/output device 2 and prompts the manager to select one completion member whose change is to be confirmed (hereinafter, referred to as "change point confirming member").

Next, the processing shifts to S304, and the change point extracting unit 6 acquires data on a member shape of the change point confirming member selected in S303 from the completion database 3 (any of or a combination of the completion member vertex model table 32, the completion member straight line model table 33, the completion member quadrangle model table 34, the completion member circle model table 35, the completion member shape pattern table 36, and the completion member component table 37).

Next, the processing shifts to S305, and the change point extracting unit 6 prompts the manager to select one point whose change is to be confirmed (hereinafter, referred to as "confirming point") among the environment acquisition coordinates, and determines whether coordinates of the confirming point fall within a member range of the change point confirming member. When the confirming point is of the change point confirming member, the processing shifts to Step S307 (YES), and when the confirming point is not of the change point confirming member, the processing shifts to Step S306 (NO) . When the change point extracting unit 6 automatically selects a confirming point, selection is made according to a predetermined rule so as not to cause overlapping. For example, when environment acquisition result IDs (refer to FIG. 3) are identified by numbers, the environment acquisition result IDs are arranged in descending order, and are selected in order from top to bottom. Concerning the determination as to whether a confirming point falls within a member range of a change point confirming member, not only a confirming point whose coordinates are completely included in the change point confirming member but also a point falling within an acceptable error range set in advance can be determined to be of the change point confirming member. For determining whether a confirming point falls within a member range of a change point confirming member, processing of "member in-range determining unit" described in Patent Literature 3 may be performed.

In the case where the processing shifts to Step S306, the confirming point is not of the change point confirming member, so that for the confirming point, the change point extracting unit 6 assigns new identification information (change confirmation ID), and stores the change confirmation ID and environment acquisition coordinates of the confirming point in the environment confirmation table 42 together with a member ID (linked to the completion member table 31) of the change point confirming member, and determines "Changed, " and the processing shifts to Step S307.

When the processing shifts to Step S307, the change point extracting unit 6 determines whether confirming point confirmation has finished for all completion members of the completion model. When there are completion members for which confirmation has not finished yet, the processing returns to Step S303, and another completion member is selected as a change point confirming member and the flow is repeated. After confirmation is finished for all completion members, the processing shifts to Step S308.

When the processing shifts to Step S308, the change point extracting unit 6 determines whether all environment acquisition coordinates acquired in S302 have been completely confirmed. When there are coordinates that have not been confirmed yet, the processing returns to Step S302, different coordinates are selected as a confirming point, and the flow is repeated. After all coordinates are confirmed, the management processing is ended.

### (Management Method: Change Point Confirmation)

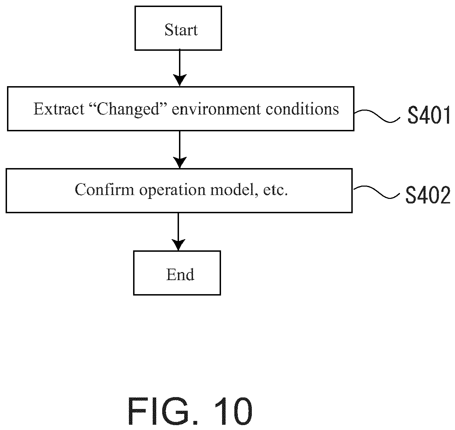

FIG. 10 is a flowchart of a management method according to the third embodiment of the present invention, illustrating a flow to confirm a change point. In the management system 1", when management processing (change point confirmation) is started, in Step S401, the change point extracting unit 6 accesses the environment database 4, reads out the environment confirmation table 42, and extracts environment conditions to which "Changed" has been assigned. Next, the processing shifts to S402, and the change point extracting unit 6 reads out the completion member table 31, the environment conditions table 41, and the operation member table 81 based on a member ID and environment acquisition coordinates of the environment conditions extracted in Step S401, and presents element attributes information and an operation model of a changed completion member or object on the display unit, etc., of the input/output device 2 so that the manager can confirm them.

As described above, according to the management system 1" and the management method of the present embodiment, a change in environment conditions since completion, that is, a displacement of a completion member or an element that had not been present at the time of completion can be extracted.

It is also preferable that in the environment confirmation table 42, confirmation attributes (confirmed/unconfirmed) are further provided, and "Confirmed" is assigned to an element that the manager confirmed in Step S402 described above, and an element which has "Changed" and to which "Unconfirmed" is assigned as confirmation attributes is extracted in Step S401. It is preferable that when "Confirmed" is assigned, a date and time of the confirmation are also stored.

Preferred embodiments and modifications of the present invention have been described above, and the embodiments and modifications can be combined based on the knowledge of a person skilled in the art, and such a combined embodiment is also included in the scope of the present invention.

In the embodiments and modifications, a management system and method for reflecting changes in environment conditions after completion of a building in "data of building at the time of completion" have been described, however, the present invention is also a system and method capable of managing a building by reflecting changes in environment conditions of the building in a previously created operation model and continuously updating the operation model. Therefore, BIM can be utilized in various operations ranging from design planning to repair of the building, that is, an entire life cycle of the building.

### Reference Signs List

1, 1', 1": Management system
2: Input/output device
3: Completion database
31: Completion member table
4: Environment database
41: Environment conditions table
42: Change confirmation table
5: Operation model creating unit
6: Change point extracting unit
7: Change point confirming unit
8: Operation database
81: Operation member table
9: Tool work management system
91: Network
92: Camera
921: Stereo camera
922: Prism
93: Total station
94: Tool
941: Trigger switch
10: Server computer

## Claims

1. A management system comprising:
a completion database storing, with respect to a completion member of a building, at least a member ID and member coordinates;
an environment database storing, with respect to environment conditions of the building including the completion member after completion or an object related to the completion member, at least an environment acquisition result ID and environment acquisition coordinates;
an operation model creating unit configured to extract, as an operation member, the completion member related to the environment conditions acquired, and create an operation model of the operation member; and
an operation database in which, with respect to the operation member, an operation member ID, the member ID, operation member coordinates, and an operation member shape are stored based on the operation model.

2. A management method comprising the steps of:
by transmitting and receiving information to and from a completion database storing, with respect to a completion member of a building, at least a member ID and member coordinates, and an environment database storing, with respect to environment conditions of the building including the completion member or an object related to the completion member, at least an environment acquisition result ID and environment acquisition coordinates,
(A) acquiring the environment conditions from the environment database;
(B) extracting, as an operation member, the completion member related to the environment conditions acquired in Step (A) ;
(C) creating, with respect to the operation member, an operation model by applying shape correction to a completion model created from the completion database by using data on the environment conditions; and
(D) storing, with respect to the operation member, an operation member ID, the member ID, operation member coordinates, and an operation member shape in an operation database based on the operation model.

3. The management system according to Claim 1, further comprising:
a tool work management system including a tool having a communication unit and a trigger switch, a total station having a communication unit, a distance-measuring unit, an angle-measuring unit, and a tracking unit, and a camera having a communication unit, a stereo camera, a posture detecting device, a control unit, and a prism, wherein
coordinates of a tip end position of the tool obtained by the tool work management system are acquired as the environment acquisition coordinates and stored in the environment database.

4. The management method according to Claim 2, further comprising the step of:
by transmitting and receiving information to and from a tool work management system including a tool having a communication unit and a trigger switch, a total station having a communication unit, a distance-measuring unit, an angle-measuring unit, and a tracking unit, and a camera having a communication unit, a stereo camera, a posture detecting device, a control unit, and a prism,
(E) receiving coordinates of a tip end position of the tool as the environment acquisition coordinates from the tool work management system and storing the received coordinates in the environment database, wherein
the operation model is created through the step (C) or the step of (F) creating, as an operation model of the operation member, a shape model representing a member shape of the completion member from the environment acquisition coordinates acquired by the tool work management system.

5. The management system according to Claim 1 or 3, comprising:
the environment database further including
a change point extracting unit configured to acquire the environment acquisition coordinates in the environment database, select the completion member whose change is to be confirmed, as a change point confirming member, and extract coordinates not falling within a member range of a member shape of the change point confirming member among the environment acquisition coordinates as "Changed," and
a change confirmation table storing, with respect to the environment acquisition coordinates extracted as "Changed" by the change point extracting unit, a change confirmation ID, the member ID, the environment acquisition coordinates, and the presence/absence of a change, in association with each other.

6. The management method according to Claim 2 or 4, further comprising the steps of:
(G) creating a completion model from the completion database;
(H) acquiring the environment acquisition coordinates from the environment database;
(I) selecting the completion member whose change is to be confirmed as a change point confirming member from the completion model;
(J) acquiring a member shape of the change point confirming member;
(K) extracting coordinates not falling within a member range of the member shape of the change point confirming member as "Changed" among the environment acquisition coordinates; and
(L) creating a change confirmation table in which, with respect to the environment acquisition coordinates extracted as "Changed" in the step (K), a change confirmation ID, the member ID, the environment acquisition coordinates, and the presence/absence of a change, are associated with each other, and storing the change confirmation table in the environment database.

7. The management method according to Claim 6, comprising the step of:
(M) extracting the environment conditions stored as the "Changed" from the change confirmation table, and presenting the extracted environment conditions to a manager.

8. A management program describing the management method according to any one of Claims 2, 4, 6, and 7 as a computer program and enabling execution of the computer program.
